# EUROPÄISCHE PATENTSCHRIFT

(11) **EP 1 397 528 B1**
(45) Veröffentlichungstag und Bekanntmachung des Hinweises auf die Patenterteilung: **08.07.2009**
(21) Anmeldenummer: 01980228.9
(22) Anmeldetag: 01.08.2001
(51) Int. Cl.: C23C 16/44

(54) **CVD-REAKTOR MIT GASAUSLASSRING AUS MASSIVEM GRAFIT**
CVD REACTOR WITH EXHAUST RING MADE OF GRAPHITE
REACTEUR CVD AVEC ANNEAU D'EXTRACTION EN GRAPHITE

(30) Priorität: 01.09.2000 DE 10043599
(43) Veröffentlichungstag der Anmeldung: 17.03.2004
(73) Patentinhaber: Aixtron AG, 52072 Aachen (DE)
(72) Erfinder: JÜRGENSEN, Holger, 52072 Aachen (DE); STRAUCH, Gerd, 52072 Aachen (DE); KÄPPELER, Johannes, 52146 Würselen (DE)
(74) Vertreter: Grundmann, Dirk
(86) Internationale Anmeldenummer: PCT/EP2001/008886
(87) Internationale Veröffentlichungsnummer: WO 2002/018670

(56) Entgegenhaltungen:
- GB-A- 1 215 140
- US-A- 4 976 217

## Beschreibung

Die Erfindung betrifft eine Vorrichtung zum Abscheiden insbesondere kristalliner Schichten auf einem oder mehreren, insbesondere ebenfalls kristallinen Substraten in einer Prozesskammer mittels in die Prozesskammer eingeleiteter und sich dort pyrolytisch umsetzender Reaktionsgase, mit einer eine Wand der Prozesskammer bildenden, rückwärtig insbesondere mit Hochfrequenz beheizbaren Trägerplatte aus insbesondere inert-beschichtetem Grafit mit einem im Zentrum der einen kreisförmigen Querschnitt besitzenden Prozesskammer angeordnetenen einer beabstandet von der Trägerplatte angeordneten Deckplatte zugeordneten Gaseinlassorgan und einem die äußere Begrenzung der Prozesskammer bildenden Gasauslassring, der eine Vielzahl von radialen Gasaustrittsöffnungen besitzt.

Eine derartige Vorrichtung ist aus der US 4,976,217 vorbekannt. Diese Schrift offenbart einen Epitaxie-Reaktor mit einer Trägerplatte, auf welcher planetenartig Substrathalter angeordnet sind, um beschichtet zu werden. Bei den Substraten handelt es sich um einkristalline Scheiben, sogenannte Wafer, die je nach Prozess aus Galliumarsenit, Indiumphosphid oder Silicium bestehen können. Die Vorrichtung besitzt ferner ein Gaseinlassorgan, durch welches die Prozessgase der Prozesskammer zugeführt werden. Die Prozessgase können metallorganische Verbindungen von Metallen der III. Hauptgruppe sein und Hydride von Elementen der V. Hauptgruppe. Es ist aber auch bekannt, als Prozessgase Silan und Propan zu versenden. Dies beschreibt die US 5,788,777. Diese Schrift beschreibt auch einen, die von unten beheizte Trägerplatte umgebenden ringförmige Gas-Kollektor. Darüber hinaus zeigt diese Schrift eine beabstandet von der Trägerplatte angeordnete Deckplatte, so dass die Prozesskammer nach unten von der Trägerplatte nach oben von der Deckplatte und in Umfangsrichtung von dem Gas-kollektor begrenzt wird. Auch die eingangs erwähnte US 4,976,217 besitzt einen Gasauslassring. Dieser ist aus einem Molybden-Blechstreifen geformt und bildet einen kronenförmigen Hohlkörper aus.

Bei der Epitaxie von Siliciumkarbit aus den Reaktionsgasen Silan und Methan/Propan muss die Temperatur in der Prozesskammer vergleichsweise hoch sein. Insbesondere soll der Temperaturgradient in der Gasphase zwischen Trägerplatte und Deckplatte möglichst flach verlaufen. Ebenso soll die Temperatur der Trägerplatte möglichst über ihrer gesamten Oberfläche nahezu gleich bleiben.

Der Erfindung liegt daher die Aufgabe zugrunde, dass Isothermenprofil innerhalb der Prozesskammer möglichst flach zu halten.

Diese Aufgabe wird durch die in den Ansprüchen angegebene Erfindung gelöst.

Der Anspruch 1 sieht vor, dass der Gasauslassring massivem Grafit besteht. Bevorzugt besteht auch die Deckplatte aus massivem Grafit und wird ebenso wie die Trägerplatte rückwärtig beheizt.

Zufolge dieser Ausgestaltung hat der Gasauslassring eine erhöhte Wärmekapazität und gleichzeitig eine gute Wärmeleitung, so dass ein gleichmäßiger Temperaturübergang von Deckplatte zu Trägerplatte vorliegt. Der Gasauslassring kann Stufen ausbilden, die von der Deckplatte übergriffen und von der Trägerplatte untergriffen werden. Der Gasauslassring liegt somit bereichsweise zwischen Deck- und Trägerplatte. Die Breite des Gasauslassringes entspricht in etwa dem Abstand zwischen Trägerplatte und Deckplatte. Bevorzugt ist der Gasauslassring einstückig aus Grafit gefertigt und besitzt eine SiC- oder TaC-Beschichtung.

Die Deckplatte und die Trägerplatte ragen mit ihrem Rand in einer Falz des Gasauslassringes ein. Es bestehen keine Radialfugen, die Ursache von Temperaturinhomogenitäten sein können. Der Gasauslassring besitzt ferner einen oberen und einen unteren Ringkragen, dessen Innenwand der Umfangsschmalwand der Trägerplatte bzw. der Deckplatte gegenüberliegt. Obwohl zwischen Ringkragen und Umfangsschmalwand ein kleiner Spalt besteht, findet doch in genügendem Maße eine Wärmeübertragung von der Trägerplatte bzw. von der Deckplatte auf den Gasauslassring statt, so dass die Temperatur des oberen Ringkragen etwa der Temperatur des Randes der Deckplatte und die Temperatur des unteren Ringkragens etwa der Temperatur des Randes der Trägerplatte entspricht. Die Deckplatte und die Trägerplatte ragen mit ihrem Rand in eine Falz des Gasauslassringes ein. Indem sich an die Außenwandung des Gasauslassringes zwei Ringvorsprünge anschließen, bildet sich zwischen diesen ein U-förmiger Ringspalt. In diesem Ringspalt münden die Gasaustrittsöffnungen. Die beiden Ringvorsprünge besitzen zufolge der guten Wärmeleiteigenschaften des Grafites eine relativ hohe Temperatur, so dass auch der Ringspalt und damit die Austrittsmündungen der Gasaustrittsöffnungen derart heiß sind, dass dort die Kondensation von Zerfallsprodukten vermindert ist. Die Ringvorsprünge haben zudem die Aufgabe, Ringplatten zur Führung des Abgases zu tragen, bzw. sich darauf abzustützen. Die Beheizung der Trägerplatte erfolgt mittels einer unterhalb ihr liegenden HF-Spule. Die Beheizung der Deckplatte erfolgt durch eine über ihr liegende HF-Spule.

Die beiden HF-Spulen können von getrennten HF-Generatoren gespeist werden. Hierdurch ist eine individuelle Regelung von Substrattemperatur und Deckentemperatur möglich. Die Substrattemperatur liegt etwa bei 1600°C. Hierzu wird die vorzugsweise aus Grafit bestehende Trägerplatte auf eine Temperatur von 1700°C bis 1800°C aufgeheizt. Die Oberflächentemperatur der aus Grafit bestehenden Deckplatte liegt etwa bei 1600°C. Auch der Bereich der Deckplatte, der unmittelbar an das Gaseinlassorgan angrenzt, besitzt eine derart hohe Temperatur. Zufolge eine Kühlung besitzt das Gaseinlassorgan eine Temperatur von unter 100°C.

Ein Ausführungsbeispiel der Erfindung wird nachfolgend anhand beigefügter Zeichnungen erläutert. Es zeigen:

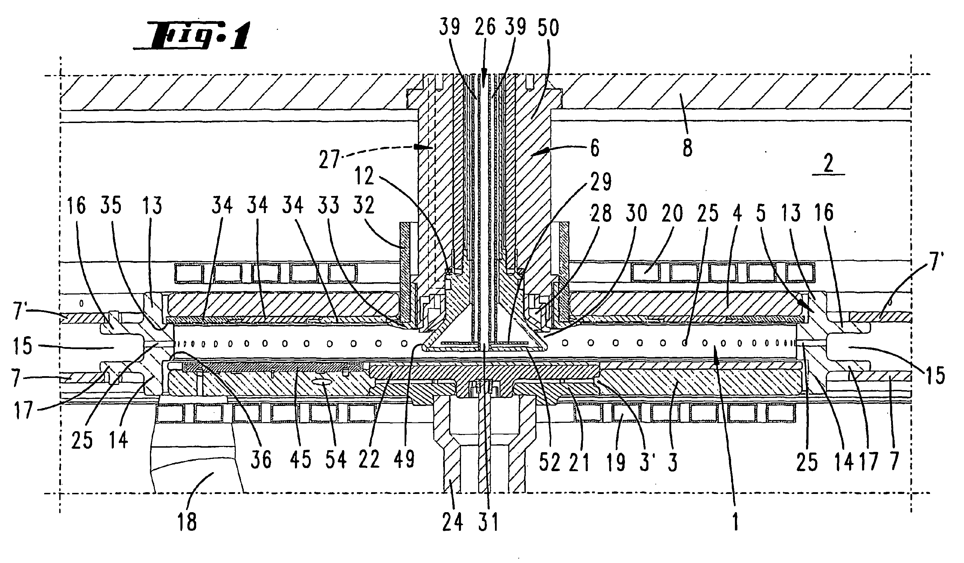

- Fig. 1: in schematischer Darstellung den Reaktor, bestehend aus der in einem Reaktorgehäuse ange- ordneten Prozesskammer und

Die im Ausführungsbeispiel dargestellte Vorrichtung dient zum monokristallinen Abscheiden von SiC-Schichten auf monokristallinen Si-Substraten in einem Heisswandreaktor. Diese Substrate können einen Durchmesser von 4 Zoll besitzen.

In dem Reaktorgehäuse 2 befindet sich die Prozesskammer 1. Diese Prozesskammer 1 besitzt eine Trägerplatte 3, die die Substrathalter 45 trägt. Parallel zur Trägerplatte 3 erstreckt sich oberhalb dieser eine Deckplatte 4. Die Trägerplatte 3 wird von unten mittels einer wassergeskühlten HF-Spule 19 beheizt. Die Deckplatte 4 wird von oben mit einer ebenfalls wassergekühlten HF-Spule 20 beheizt. Die Trägerplatte 3 ist ringförmig gestaltet, wobei der Außendurchmesser etwa doppelt so groß ist wie der Innendurchmesser. Die Innenwandung der Trägerplatte 3 besitzt eine radial einwärts ragende Ringstufe 3'. Mit dieser Ringstufe 3' liegt die Trägerplatte 3 auf dem Rand einer Stützplatte 1 auf. Die Stützplatte 1 stützt sich wiederum auf einem Stützrohr 24 ab, welches von einer Zugstange 23 durchragt wird. Die Zugstange 23 greift etwa mittig an einer oberhalb der Stützplatte 21 angeordneten Zugplatte 22 an, welche mit ihrem Rand auf den Kragen 3' aufliegt. Durch Zug an der Zugstange 23 von unten wird die Trägerplatte 3 klemmbackenartig gehalten.

Die Trägerplatte 3 und die Deckplatte 4 werden von einem Gasauslassring 5 umgeben. Dieser Gasauslassring 5 bildet die seitliche Prozesskammer-Wand. Der Randbereich der HF-Spulen 19, 20 überdeckt teilweise den Gasauslassring 5. Der Gasauslassring 5 besitzt eine Vielzahl von radialen Bohrungen 25, durch welche das Prozessgas austreten kann. Der Gasauslassring 5 ist ebenso wie die Stützplatte 21, die Zugplatte 22, die Trägerplatte 3 und die Deckplatte 4 aus massivem Grafit gefertigt. Er ist einstückig und hat eine Breite, die etwa der Höhe der Prozesskammer 1 entspricht. Hierdurch besitzt der Gasauslassring 5 eine relativ hohe Wärmekapazität, was zur Folge hat, dass das Temperaturprofil innerhalb der Prozesskammer auch am Rand sehr homogen ist. Indem der Gasauslassring 5 eine von der Deckplatte 4 überfangene Stufe 35 und eine von der Trägerplatte unterfangene Stufe 36 ausbildet, ragt er bereichsweise in den Zwischenraum von Deckplatte 4 und Trägerplatte 3.

Im Bereich der Stufe 35 besitzt der Gasauslassring 5 einen nach oben abragenden Kragen 13. Die Innenwandung des Kragens 13 liegt der schmalen Umfangswand der Deckplatte 4 gegenüber. Auch nach unten erstreckt sich ein Ringkragen 14, dessen radialeinwärts gerichtete Innenwand liegt der radialauswärts gerichteten Schmalwand der Trägerplatte 3 gegenüber.

Der Gasauslassring 14 besitzt ferner nach außen weisende Ringvorsprünge 16 und 17. Diese beiden Ringvorsprünge 16, 17 sind voneinander beabstandet und bilden einen U-förmigen Ringspalt 15 aus, in welchen die Gasaustrittsöffnungen 25 münden. Der untere Ringvorsprung 17 stützt sich auf einer Ringplatte 7 aus Quarz ab. Die Ringplatte 7 ist parallel beabstandet von einer Ringplatte 7' die ebenfalls aus Quarz besteht, und die sich auf dem oberen Ringvorsprung 16 abstützt. Zwischen den beiden Ringplatten 7 und 7' befindet sich ein Kanal, durch den das durch die Gasaustrittsöffnung 25 ausgetretene Gas einem Auspuff 18 zugeleitet wird.

Die Deckplatte 4 ist an ihrer Unterseite mit insgesamt drei Verkleidungsringen 34 ausgefüttert. Diese Verkleidungsringe können aus Grafit bestehen oder aus TaC. Sie werden ähnlich wie Ofenringe durch gegenseitigen übergriff aneinander gehalten, wobei sich der innerste Ring 34 auf einen Ringkragen eines Grafitträgers 33 abstützt, welcher auf das untere Ende eines Gaseinlass - organes 6 aufgeschraubt ist.

Das Gaseinlassorgan 6 ist insgesamt zweiteilig ausgebildet. Es besitzt einen Kern, der einen in die Prozesskammer 1 ragenden Abschnitt 49 ausbildet, welche eine Kegelstumpfgestalt besitzt. Dieser Kern wird von einem Mantel 50 umgeben. Mittels O-Ringdichtung 12 ist der Mantel 50 gegenüber dem Kern 49 abgedichtet.

Die Zuführung des Silans 5 erfolgt durch die Zuleitung 27. Es tritt durch eine ringkeilförmige Öffnung 30 aus. Die Wandung dieses Austritts 30 wird einerseits vom Kernabschnitt 49 und andererseits vom Mantel 50 ausgebildet. Die Wände des Kanals 30 sind gekühlt. Hinter den Kanalwänden befinden sich Kühlwasserkammern 28, durch welche Kühlwasser strömt, um die Wandungstemperatur unterhalb der Zerlegungstemperatur des Silans zu halten.

Die Basisfläche 52 welche ebenfalls zufolge rückwärtiger Kühlwasserbeaufschlagung bei einer Temperatur gehalten ist, bei welcher sich die Reaktionsgase nicht zerlegen, befindet sich etwa in der Mitte der Prozesskammer und verläuft parallel zur Oberfläche der Trägerplatte 3 In der Mitte der Basisfläche 52 befindet sich die Öffnung 31 der Methan- bzw. Propan-Zuleitung 26.

Um die beim Betrieb der Vorrichtung etwa bis auf 1600°C aufgeheizte Deckplatte 4 von dem gekühlten Gaseinlassorgan 6 zu isolieren, ist eine Isolationsmanschette 32 aus einem Kohlenstoffschaum vorgesehen, welche auf dem Träger 33 sitzt.

Die Trägerplatte 3 wird über das Stützrohr 24 drehangetrieben. Die Trägerplatte 3 besitzt zudem Kanäle 54, durch welche Gas strömt, welches in Spiralnuten austritt, die sich am Boden von Aussparungen befinden. In den Aussparungen liegen die Substrathalter 45 ein. Sie drehen sich auf einem Gaspolster des Gases.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Vorrichtung zum Abscheiden insbesondere kristalliner Schichten auf einem oder mehreren, insbesondere ebenfalls kristallinen Substraten in einer Prozesskammer (1) mittels in die Prozesskammer (1) eingeleiteter und sich dort pyrolytisch umsetzender Reaktionsgase, mit einer eine Wand der Prozesskammer bildenden, rückwärtig, insbesondere mit Hochfrequenz beheizbaren Trägerplatte (3) aus insbesondere inertbeschichtete, Grafit, mit einem im Zentrum der einen kreisförmigen Querschnitt besitzenden Prozesskammer (1) angeordneten, einer beabstandet von der Trägerplatte (3) angeordneten Deckplatte (4) zugeordneten Gaseinlassorgan (6) und einem die äußere Begrenzung der Prozesskammer (1) bildenden Gasauslassring (5), der eine Vielzahl von radialen Gasaustrittsöffnungen (25) besitzt, **dadurch gekennzeichnet, dass** der Gasauslassring (5) aus massivem Grafit besteht.

2. Vorrichtung nach Anspruch 1, **dadurch gekennzeichnet, dass** die Deckplatte (4) rückwärtig beheizbar ist.

3. Vorrichtung nach einem der vorhergehenden Ansprüche, **dadurch gekennzeichnet, dass** alle Wände der Prozesskammer aus massivem Grafit bestehen.

4. Vorrichtung nach einem der vorhergehenden Ansprüche, **dadurch gekennzeichnet, dass** der Gasauslassring (5) Stufen (35, 36) ausbildet, die von der Deckplatte (4) übergriffen und von der Trägerplatte (3) untergriffen werden.

5. Vorrichtung nach einem der vorhergehenden Ansprüche, **dadurch gekennzeichnet, dass** die Breite des Gausauslassringes (5) etwa dem Abstand zwischen Trägerplatte (3) und Deckplatte (4) entspricht.

6. Vorrichtung nach einem der vorhergehenden Ansprüche, **dadurch gekennzeichnet, dass** der Gasauslassring (5) einstückig ist.

7. Vorrichtung nach einem der vorhergehenden Ansprüche, **dadurch gekennzeichnet, dass** der Gasauslassring (5) einen oberen und einen unteren Ringkragen (13,14) besitzt, dessen Innenwand der Umfangsschmalwand der Trägerplatte (3) bzw. der Deckplatte (4) gegenüberliegt.

8. Vorrichtung nach einem der vorhergehenden Ansprüche, **gekennzeichnet durch** nach außen weisende, zwischen sich einen U-förmigen Ringspalt belassende Ringvorsprünge (16,17), in welchen Ringspalt (15) die Gasaustrittsöffnungen (25) münden.

9. Vorrichtung nach einem der vorhergehenden Ansprüche, **dadurch gekennzeichnet, dass** die Materialstärke von Deckplatte (4), Trägerplatte (3) und Gasauslassring (5) etwa gleich ist.

10. Vorrichtung nach einem der vorhergehenden Ansprüche, **dadurch gekennzeichnet, dass** der Gasauslassring (5) im Strahlungsfeld einer der beiden HF-Spulen (19, 20) liegt.

## Claims

1. A device for depositing in particular crystalline layers on one or more, in particular likewise crystalline substrates in a process chamber (1) by means of reaction gases which are introduced into the process chamber (1) where they react pyrolytically, having a carrier plate (3) which forms a wall of the process chamber, can be heated from the rear, in particular using high frequency and consists of in particular inert-coated graphite, having a gas-admission element (6), which is disposed in the center of the process chamber (1), the chamber being circular in cross section, and is associated with a cover plate (4) which is disposed at a spacing from the carrier plate (3), and a gas-discharge ring (5), which forms the outer boundary of the process chamber (1) and has a multiplicity of radial gas outlet openings (25), **characterized in that** the gas-discharge ring (5) consists of solid graphite.

2. The device according to claim 1 , **characterized in that** the cover plate (4) can be heated from the rear.

3. The device according to one of the preceding claims, **characterized in that** all the walls of the process chamber consist of solid graphite.

4. The device according to one of the preceding claims, **characterized in that** the gas-discharge ring (5) forms steps (35, 36) over which the cover plate (4) engages and under which the carrier plate (3) engages.

5. The device according to one of the preceding claims, **characterized in that** the width of the gas-discharge ring (5) approximately corresponds to the spacing between carrier plate (3) and cover plate (4).

6. The device according to one of the preceding claims, **characterized in that** the gas-discharge ring (5) is in single-part form.

7. The device according to one of the preceding claims, **characterized in that** the gas-discharge ring (5) has an upper and a lower annular collar (13, 14), the inner wall of which lies opposite the circumferential narrow wall of the carrier plate (3) or of the cover plate (4).

8. The device according to one of the preceding claims, **characterized by** annular protuberances (16, 17) which face outward and leave a U-shaped annular gap between them, into which annular gap (15) the gas outlet openings (25) open out.

9. The device according to one of the preceding claims, **characterized in that** the material thickness of cover plate (4), carrier plate (3) and gas-discharge ring (5) is approximately equal.

10. The device according to one of the preceding claims, **characterized in that** the gas-discharge ring (5) is located in the radiation field of one of the two HF coils (19, 20).

## Revendications

1. Dispositif de dépôt de couches, notamment cristallines, sur un ou plusieurs substrats, notamment également cristallins, dans une chambre de réaction (1) au moyen de gaz de réaction injectés dans la chambre de réaction (1) où ils sont transformés par pyrolyse, ledit dispositif comportant une plaque de support (3) en graphite, notamment doté d'un revêtement inerte, qui forme une paroi de la chambre de réaction et qui peut être chauffée par l'arrière, notamment à haute fréquence, un organe d'injection de gaz (6) qui est associé à une plaque de recouvrement (4) disposée à distance de la plaque de support (3) et disposé au centre de la chambre de réaction (1), de section circulaire, et une bague de sortie de gaz (5) qui forme la limite extérieure de la chambre de réaction (1) et qui possède une pluralité d'ouvertures radiales de sortie de gaz (25), **caractérisé en ce que** la bague de sortie de gaz (5) est en graphite massif.

2. Dispositif selon la revendication 1, **caractérisé en ce que** la plaque de recouvrement (4) peut être chauffée par l'arrière.

3. Dispositif selon l'une des revendications précédentes, **caractérisé en ce que** toutes les parois de la chambre de réaction sont en graphite massif.

4. Dispositif selon l'une des revendications précédentes, **caractérisé en ce que** la bague de sortie de gaz (5) forme des gradins (35, 36) qui sont recouverts du côté supérieur par la plaque de recouvrement (4) et du côté inférieur par la plaque de support (3).

5. Dispositif selon l'une des revendications précédentes, **caractérisé en ce que** la largeur de la bague de sortie de gaz (5) correspond approximativement à la distance entre la plaque de support (3) et la plaque de recouvrement (4).

6. Dispositif selon l'une des revendications précédentes, **caractérisé en ce que** la bague de sortie de gaz (5) est d'une seule pièce.

7. Dispositif selon l'une des revendications précédentes, **caractérisé en ce que** la bague de sortie de gaz (5) possède des rebords annulaires supérieur et inférieur (13, 14) dont la paroi intérieure se trouve en face de la paroi périphérique étroite de la plaque de support (3) ou, respectivement, de la plaque de recouvrement (4).

8. Dispositif selon l'une des revendications précédentes, **caractérisé par** des saillies annulaires (16, 17), pointant vers l'extérieur, qui ménagent entre elles une fente annulaire (15), en forme de U, dans laquelle débouchent les ouvertures de sortie de gaz (25).

9. Dispositif selon l'une des revendications précédentes, **caractérisé en ce que** l'épaisseur de matériau est à peu près la même pour la plaque de recouvrement (4), la plaque de support (3) et la bague de sortie de gaz (5).

10. Dispositif selon l'une des revendications précédentes, **caractérisé en ce que** la bague de sortie de gaz (5) est située dans le champ de rayonnement de l'une des deux bobines HF (19, 20).
